# EUROPEAN PATENT APPLICATION

(11) **EP 4 049 969 A1**
(43) Date of publication of application: **31.08.2022**
(21) Application number: 20879303.4
(22) Date of filing: 23.10.2020
(51) Int. Cl.: C01B 32/168, B82Y 30/00, B82Y 40/00, C01B 32/159, C23C 26/00

(54) **CARBONACEOUS STRUCTURE FORMING METHOD AND SUBSTRATE HAVING CARBONACEOUS STRUCTURE**

(30) Priority: 26.10.2019 JP 2019194828
(71) Applicant: National University Corporation Yamagata University, Yamagata-shi, Yamagata 990-8560 (JP); Nissan Chemical Corporation, Tokyo 103-6119 (JP)
(72) Inventor: ISHIZAKI Manabu, Yamagata-shi Yamagata 990-8560 (JP); KURIHARA Masato, Yamagata-shi Yamagata 990-8560 (JP); MATSUI Jun, Yamagata-shi Yamagata 990-8560 (JP)
(74) Representative: Vossius & Partner Patentanwälte Rechtsanwälte mbB
(86) International application number: PCT/JP2020/039920
(87) International publication number: WO 2021/079990

(57) **Abstract**

An object of the present invention is to provide a novel method for forming a carbonaceous structure comprising minute carbon bodies such as CNTs. A method for forming a carbonaceous structure on the surface of a substrate, comprising a step of forming a layered structure by at least partially filling a gap between a porous membrane which can hold a dispersion medium and a substrate with a minute-carbon-body dispersion liquid comprising the minute carbon bodies and the dispersion medium, and a step of removing the dispersion medium by at least partially taking the dispersion medium out of the layered structure through the porous membrane and/or the substrate.

## Description

### Technical Field

The present invention relates to a method for forming a carbonaceous structure and a substrate comprising the carbonaceous structure.

### Background Art

Various semiconductor devices including display devices require wiring layers to electrically connect components, such as a transistor, a capacitor, and a photoelectric conversion which constitute the device. So far, the wiring layers were generally made of metal phases, such as gold, silver, and aluminum which show high electric conductivity. Recently, the attempts to make the wiring layers of the devices have been widely conducted by using minute carbon bodies made of extremely minute carbon fibers and carbon particles, such as carbon nanotube (CNT) and graphene which are formed by carbon atoms with sp² hybridization.

By making use of very high field electron emission characteristics of the tip of the CNT, CNT-containing membranes are expected to be used as electrodes of the field emission cold cathode which is used for a fluorescent display tube, an X-ray tube and a field emission display (FED). The CNT-containing membranes themselves are also expected to be used as semiconductor components by adjusting the shape of the minute carbon bodies and replacing part of the carbon atoms with other atoms.

When wiring layers of the device are formed with minute carbon bodies, a structure of a carbonaceous membrane containing the minute carbon bodies is required for the formation process of carbonaceous structure, which forms whole or part of a prescribed substrate.

The following method for forming the carbonaceous structure on the surface of the substrate has been investigated: the method for forming the structure such as the carbonaceous membrane on the substrate by using techniques like printing methods where a paste prepared by mixing minute carbon bodies such as CNT with appropriate binders or a dispersion liquid prepared by dispersing the minute carbon bodies in an appropriate dispersion medium is applied to the surface of the substrate. Such techniques as printing method can stabilize the process and reduce the cost for forming the carbonaceous structure.

However, minute carbon bodies such as CNT are not necessarily easy to form a highly concentrated dispersion liquid including minute carbon bodies, because generally they have low wettability to solvents. Once adhered to various surfaces, it is often difficult to remove the minute carbon bodies. That is to say, it is difficult to use the techniques like printing methods because of the unique characteristics of the minute carbon bodies such as CNTs. Hence, various methods have been investigated to avoid such problems.

For example, in order to avoid the difficulties forming a dispersion liquid containing CNTs with high concentration, the following transfer process has been investigated: a dispersion liquid containing CNT with low density is filtrated through a filter and then an accumulation of the CNTs on the filter is transferred to the surface of a desired substrate.

For example, Patent Literature 1 discloses a method for adhering the carbonaceous aggregate to the metal surface, where CNT-based carbonaceous substances as adhesive preparatory bodies are accumulated on filter paper, then the adhesive preparatory bodies are placed on the smooth surface of a metal, and heated under a loading condition to transfer the CNT-based carbonaceous substance to the metal surface. The obtained product is used as FED and capacitor components. Patent Literature 2 discloses a method for transferring a CNT membrane to the substrate, where a CNT dispersion liquid is filtrated to give a filter on which CNT is accumulated, then the filter is placed on the metal substrate for electron source and then pressed to transfer the CNT membrane to the substrate. Non-patent Literature 1 discloses a method for transferring a CNT membrane to the substrate, where a CNT membrane prepared by filtrating a CNT dispersion liquid and drying it on a filter is put into contact with and pressed to adhere to the substrate, and then the filter adhered to the CNT membrane is dissolved away with an organic solvent.

Patent Literature 3 discloses the following: a method of adhering predetermined metal catalysts to the surface of the substrate to which a carbonaceous membrane is expected to be formed without going through dispersion medium, and then growing CNT on the metal catalyst by chemical vapor deposition (CVD); a method of electrodepositing CNTs synthesized in advance on the substrate by the action of static electricity; and a technique of forming a transparent conductive film, where CNT grown in the gas phase is gathered on a filter to form a structure and the structure is transferred to form the transparent conductive film. According to Non-patent Literature 2, CNTs grown in a gas phase are gathered on a filter to be an adhesive preparatory body and after the adhesive preparatory body is pressed on the smooth substrate, the filter is peeled off to form a CNT transparent conductive film on the substrate.

### Citation List

### Patent Literature

PTL 1: JP 2008-273785 A
PTL 2: JP 2011-009131 A
PTL 3: JP 2014-044839 A

### Non-patent Literature

NPL 1: Science, 305, 1273 (2004)
NPL 2: Nano Letters, 10, 4349 (2010)

### Summary of Invention

### Technical Problem

As described above, due to various characteristics mainly held by minute carbon bodies such as CNTs, methods for forming the carbonaceous structure on the substrate using the minute carbon bodies cannot be said to be established.

As to the methods using a dispersion liquid in which minute carbon bodies are dispersed in volatile dispersion medium, choice of dispersion media are limited due to difficulty of satisfactorily dispersing the minute carbon bodies in the dispersion medium high densely; while wettability to the surface of the substrate is unsatisfactory, depending on the type of dispersion medium, and in such circumstances, it is difficult to form a uniform liquid membrane of the dispersion medium on the predetermined portion of the surface of the substrate.

In technique where CNTs are accumulated on a filter by a gas phase method to form a preparatory molding body and then the preparatory molding body is transferred to a substrate to form a carbonaceous structure on the surface of a substrate, the process of pressing the preparatory molding body against the substrate under a predetermined pressure is required to give a compressed carbonaceous structure because the preparatory molding body generally has low density. In a method where a dispersion liquid of minute carbon bodies such as CNTs is not prepared, there are not many occasions in which catalysts adhered to the minute carbon bodies are removed or various modifications are conducted. There is also a problem in the process of removing the filter adhered to the carbonaceous structure after the minute carbon bodies are transferred.

As described above, in the foregoing method, a low-density preparatory molding body is formed on the surface of filters in advance and transferred to give a carbonaceous structure. However, the problem becomes conspicuous when a wiring layer is formed on the substrate equipped with semiconductor structures in advance, that is, when the so-called top contact type structure is formed. Therefore, on using this method, the choice of dispersion medium which does not damage the semiconductor structure of a base substrate and the proper method for pressing the preparatory molding body are required, which complicates the process of forming the carbonaceous structure.

When the minute carbon bodies such as CNTs are used for semiconductor devices including carbonaceous structures, such as the wirings, transparent conductive films, electrodes and semiconductor structures, this carbonaceous structure to be formed not only shows the desired characteristics, but also does not damage the structure which has been already formed when the carbonaceous structure is formed. Besides, there are still a variety of needs for structures and manufacturing processes for different semiconductor devices with low cost and high productivity.

Paying attention in light of the above-mentioned needs will provide a method for forming a novel carbonaceous structure that is different from existing techniques. The existing semiconductor device structure will be easily formed and a novel semiconductor device structure will be also expected to be formed.

An object of the present invention is to provide a method for forming a novel carbonaceous structure and a substrate formed therefrom, especially regarding the method in which a carbonaceous structure is formed using a dispersion liquid containing minute carbon bodies such as CNTs.

### Solution to Problem

In order to solve the problems, the present invention provides a formation method of a carbonaceous structure on the surface of the substrate, comprising a formation step of a layered structure by at least partially filling a gap between a porous membrane which can hold a dispersion medium and a substrate with a minute-carbon-body dispersion liquid including the minute carbon bodies and the dispersion medium, and a step of at least partially removing the dispersion medium from the layered structure through the porous membrane and/or the substrate.

In the foregoing method, provided is the formation method for a carbonaceous structure, wherein the layered structure is formed by overlaying the substrate with the porous membrane on which the minute-carbon-body dispersion liquid is held by suction filtration.

In the foregoing method, provided is the formation method for a carbonaceous structure, wherein the porous membrane on which the minute-carbon-body dispersion liquid is suction filtrated and held is further soaked in a solvent, and then is overlaid on the substrate to form the layered structure.

In the foregoing method, provided is the formation method for a carbonaceous structure, wherein the dispersion medium contained in the minute-carbon-body dispersion liquid is replaced with other dispersion medium in the suction filtration process.

In the foregoing method, the step of removing the dispersion medium provides the formation method for a carbonaceous structure, wherein the dispersion medium is vaporized through the pores of the porous membrane.

The foregoing method further comprises a step of removing the porous membrane from the carbonaceous structure thus formed.

The removal step of the porous membrane provides the formation method for a carbonaceous structure, wherein the porous membrane is peeled off the carbonaceous structure.

The present invention provides a substrate of a carbonaceous structure containing minute carbon bodies, wherein through a porous membrane and/or the substrate, the carbonaceous structure is formed in the process of at least partially taking a dispersion medium out of a layered structure obtained by at least partially filling a gap between the porous membrane which can hold the dispersion medium and the substrate with a minute-carbon-body dispersion liquid comprising the minute carbon bodies and the dispersion medium.

### Advantageous Effects of Invention

According to the present invention, the carbonaceous structure can be formed easily and efficiently. By having a specified structure especially in the lower part, the carbonaceous structure can be excellently formed on the uneven or curved surface.

### Brief Description of Drawings

Fig. 1A represents a PET substrate coated with CNT film using the CNT aqueous dispersion.
Fig. 1B represents a PET substrate coated with CNT film using the CNT aqueous dispersion.
Fig. 2A represents a SEM image of CNT coating film formed using the CNT aqueous dispersion.
Fig. 2B represents a SEM image of CNT coating film formed using the CNT aqueous dispersion.
Fig. 2C represents a SEM image of the section of CNT coating film formed using the CNT aqueous dispersion.
Fig. 3 represents a PET substrate coated with CNT film using the toluene dispersion of CNT.
Fig. 4A represents a glass substrate coated with CNT film using the toluene dispersion of CNT.
Fig. 4B represents a fluorocarbon polymer (Cytop)-treated glass substrate that is coated with CNT film using the toluene dispersion liquid of CNT.
Fig. 4C represents a polycycloolefin resin coated with CNT film using the toluene dispersion of CNT.
Fig. 4D represents a PTFE resin coated with CNT film using the toluene dispersion of CNT.
Fig. 4E represents the curved surface of glass that is coated with CNT film using the toluene dispersion of CNT.
Fig. 4F represents the surface of aluminum foil coated with CNT film using the toluene dispersion of CNT.
Fig. 4G represents a rubber glove (nitrile rubber) coated with CNT film using the toluene dispersion of CNT.
Fig. 5A represents a PET substrate coated with mixed film of CNT and graphene using the toluene dispersion of CNT and graphene.
Fig. 5B represents a SEM image of mixed coating film of CNT and graphene formed using the toluene dispersion of CNT and graphene.
Fig. 6 represents a schematic drawing of droplet soaked in the porous membrane.

### Description of Embodiments

A feature of the present invention lies in the formation of a carbonaceous structure with the minute carbon bodies by making good use of various behaviors observed in coexistence of liquid and a porous membrane.

### 1. Use of porous membrane used in the present invention:

The porous membrane in the present invention forms a layered structure together with a substrate via a dispersion liquid with minute carbonaceous structures, which thereby prevents the dispersion liquid from forming droplets on the surface of the substrate, helps the dispersion liquid to be distributed approximately even on the surface of the substrate, and keeps the minute carbonaceous bodies in the dispersion liquid between the substrate and the porous membrane. In the process of discharging dispersion medium between the substrate and the porous membrane through the pores of the porous membrane, the porous membrane serves as a pressure medium to make the porous membrane compress the dispersoid isotropically by atmospheric pressure.

A spin coating method and an atomizing method are used in general as the means of forming an approximately even liquid membrane by feeding various liquids to the surface of the substrate. The dispersion liquid of the minute carbon bodies used in the present invention is also expected to form a uniform liquid membrane on the surface of the substrate by mainly adjusting the dispersion medium by the spin coating method and the like.

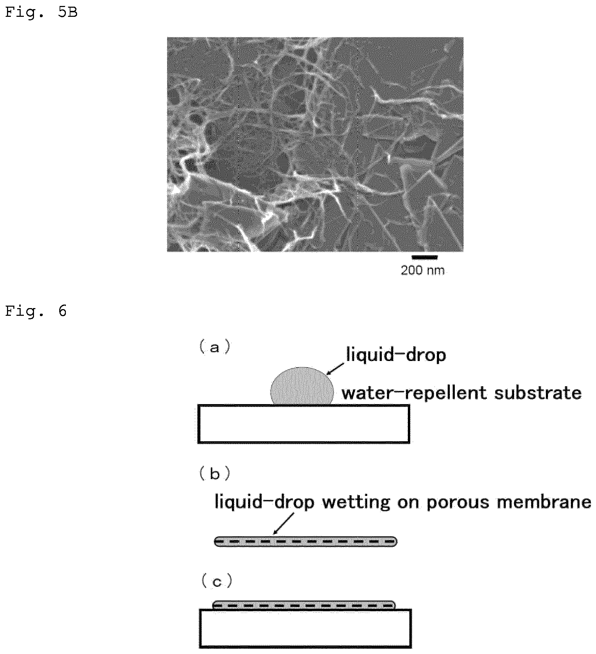

However, as schematically shown in Fig. 6(a), when the wettability between the liquid and the surface of the substrate is low, the contact area between the liquid and the surface of the substrate is reduced due to the surface tension of the liquid. The liquid forms droplets on the surface of the substrate because of its action to minimize the surface area. As a result, it is difficult to form the even liquid membrane. Especially, this phenomenon is distinct when the thinner liquid membrane is intended.

As schematically shown in Fig. 6(b), when the liquid is dropped on the surface of the porous membrane over a certain level of wettability, the liquid penetrates and fills pores of the porous membrane by so-called capillarity action, and on the surface of the porous membrane, the liquid membrane is generated so as to join the liquids filling the pores. A phenomenon of the "filmy liquid-drop" covering the whole porous membrane is usually observed. When the porous membrane is impregnated with the liquid, the appearance of the liquid varies, and an approximately uniform liquid membrane is stably formed on the surface of the porous membrane, which is generally observed. In the present specification, such a liquid form where the liquid including all or part of the porous membrane spreads like a thin film may be referred to as the "liquid-drop wetting on the porous membrane."

For example, the surface of the substrate made of fluorocarbon polymer etc., with high water repellency shows a tendency to form a liquid-drop when being in contact with the liquid such as water itself (Fig. 6 (a)). However, when the porous membrane is impregnated with an adequate amount of the liquid and the resulting "liquid-drop wetting on the porous membrane" is formed on the surface, the porous membrane etc., are stably put on the surface of the substrate, which is also generally observed (Fig. 6(c)). The liquid membrane between the porous membrane and the surface of the substrate is of approximately uniform thickness, regardless of the shape of the surface of the substrate.

The present invention is aimed at forming a desired carbonaceous structure on the surface of the substrate by making use of the above phenomenon of the liquid wetting the porous membrane. When the dispersion liquid containing the dispersion medium is suppressed to form a liquid-drop on the surface of the substrate, even if the dispersion medium having low wettability to the substrate is used.

In other words, in one aspect of the present invention, the porous membrane is placed on the surface of the substrate to form a carbonaceous structure and is layered to be a layered structure via a dispersion liquid in which minute carbon bodies composing the carbonaceous structure are dispersed. The porous membrane closely adheres to the substrate by the surface tension of the dispersion liquid. The dispersion liquid forms and maintains an approximately uniform liquid membrane on the surface of the substrate, regardless of wettability to the substrate.

Even when because of the use of flexible porous membrane, the surface of the substrate is uneven or curved, the porous membrane deforms autonomously by the surface tension and adheres to the substrate, which enables the substrate to retain the dispersion liquid membrane in approximately the same thickness as the substrate does on the plane. Compared with the case in dried condition, porous membrane is damp from dispersion liquid, so that delicate wrinkles and shrinkages are autonomously dissolved. Therefore, irregularity and positional deviation in the carbonaceous structures are prevented effectively.

By using the porous membrane whose pore size is actually too narrow for minute carbon bodies to pass through, minute carbon bodies can be practically confined between the substrate and the porous membrane and enables the formation of the carbonaceous structure easily, which is effective.

In another aspect of the present invention, concerning the layered structure in which the substrate and the porous membrane layered via dispersion liquid where the above minute carbon bodies are dispersed, for example, dispersion medium in the dispersion liquid is gradually vaporized from the backside of the porous membrane on the substrate. The dispersion medium between the porous membrane and the substrate is drawn out of the pores of the porous membrane. As a result, the distance between the substrate and the porous membrane is reduced. The minute carbon bodies which are dispersoid existing between the substrate and the porous membrane are compressed and aggregated into a carbonaceous structure.

The power of compressing the above-mentioned minute carbon bodies between the substrate and the porous membrane functions as the isotropic hydrostatic pressure exerted by atmospheric pressure through the flexible porous membrane, and acts uniformly on the surface of the substrate regardless of its shape. The isotropic hydrostatic pressure is particularly helpful when an upper electrode in a top contact structure is formed, because it does not damage the structure formed on the surface of the substrate in advance.

### 2. Method for forming a carbonaceous structure of the present invention:

### (1) Minute carbon bodies used in the present invention:

Minute carbon bodies such as CNT, graphene and fullerene, preferably delicate and uniform minute carbon bodies obtained by industrial technique are used for the formation of the carbonaceous structure in the present invention. Based on hexagonal lattice structure formed by carbon atoms, CNTs have unique secondary structure in the combination of one or several layers, showing unique chemical and physical characteristics. Particularly, by making use of high conductivity of CNT and graphene and semiconducting properties of part of CNT and a kind of fullerene show, distinguished carbonaceous structures are possibly formed. However, due to the extremely high specific surface area of minute carbon bodies such as CNTs have, there are various difficulties in the process of forming the carbonaceous structure by means of a method like a printing technique.

In the present invention, as dispersion medium, a solvent with volatility, which is easy to be removed, and a dispersion liquid in which minute carbon bodies are dispersed, are prepared in advance. The surface of various kinds of minute carbon bodies are covered with a dispersion medium, suppressing the appearance of various characteristics of minute carbon bodies each other, or a strong adhesion of minute carbon bodies to the porous membrane nearby and so on. Thus, the carbonaceous structures are formed by the method such as a printing technique in solution process.

### (2) Dispersion liquid:

In the process of forming the carbonaceous structure on the substrate in the present invention, the dispersion liquid is prepared by dispersing minute carbon bodies to form the carbonaceous structures in an appropriate dispersion medium. In the present invention, dispersion means that dispersoid has the surface covered with dispersion medium because of impregnation with the dispersion medium. The dispersoid may aggregate to the extent that aggregates can be easily redispersed between the dispersoids or between the dispersoid and the porous membrane. In the present invention, after the dispersion liquid is homogenized by ultrasonic and the other stirring processes, minute carbon bodies are required only to stay in the dispersion medium approximately homogeneously over the predetermined time. In the dispersion liquid, not only is the dispersoid stable without showing any substantial interaction, but also may precipitate after the dispersion medium stands still for a long time after stirred. The dispersoid may precipitate as long as it can be easily redispersed in the dispersion medium. The surface of the minute carbon bodies is coated with the dispersion medium by holding the minute carbon bodies in the dispersion liquid, which thereby does not easily cause strong adhesion between the minute carbon bodies, or among the porous membrane, the substrate surface and the minute carbon bodies.

In the present invention, structures of minute carbon bodies used for the formation of the carbonaceous structure are not particularly restricted, and can be determined according to the desired carbonaceous structure as long as they can be approximately homogeneously stay in dispersion media by ultrasonic and the other stirring processes. The minute carbon bodies include carbon nanotube (CNT), graphene and fullerene.

Auxiliary agents with surfactant action enhance an affinity with dispersion medium and facilitate dispersion. By using the auxiliary agent as necessary, the minute carbon bodies can be used in a dispersed state in the dispersion medium. For example, when the CNT is used as minute carbon bodies as above, surfactants such as sodium dodecyl sulfate, sodium dodecylbenzenesulfonate, dodecyltrimethylammonium bromide, Triton X-100 and polyvinylpyrrolidone, whose surface-active effects are already known, can be used. The use of carbonaceous compounds having aromatic rings, such as cresol enables highly concentrated CNT to be dispersed into the suitable dispersion medium. The use of acidic liquids, such as sulfonic acid chloride enables highly concentrated CNT to be dispersed. In addition, alkali metal salts and ammonium salts may be used as dispersion aids to enhance dispersibility of CNT in alcohols, etc.

The minute carbon bodies used in the present invention do not have to be composed of high-purity carbons and may contain various additives and impurities depending on the aim of the carbonaceous structure. In the dispersion liquid of the present invention, other components besides the minute carbon bodies may be included according to the aim of the carbonaceous structure.

The density of the minute carbon bodies in the dispersion liquid used in the present invention can be determined in an appropriate manner according to the kind of minute carbon bodies and dispersion media to be used, and according to the kind of a carbonaceous structure and a specific formation method thereof. The density is, for example, 5, 0.1, 0.01 and 0.001 wt%. When a membrane filter is used as the porous membrane and the minute carbon bodies are concentrated on the porous membrane by means of suction filtration, the dispersion liquid containing the minute carbon bodies with lower density can be used.

The dispersion media in the dispersion liquid used in the present invention are not particularly restricted. Solvents, such as toluene, chlorobenzene, ethanol, 2-methoxyethanol, ethylene glycol, acetone, methyl ethyl ketone, ethyl acetate, hexane, octane, terpineol, γ-butyrolactone, chloroform, DMF, DMSO, THF and water can be used as a main component. The dispersion medium can be chosen appropriately, considering the surfactants, the demands mainly for the substrate (e.g., wettability with the substrate, corrosion to the substrate, etc.,), and volatility in removing the solvents.

Demand for the substrate on which the carbonaceous structure is formed may be realized in the following way: a dispersion liquid of minute carbon bodies is filtrated through the porous membrane to enrich the minute carbon bodies; the dispersion medium is replaced with another dispersion medium supplied while the dispersion medium is removed by suction; and after that, a carbonaceous structure may be placed on the substrate as a layered structure.

### (3) Porous membrane used in the present invention:

The porous membrane used in the present invention can be used appropriately, provided that the porous membrane has pores communicating from the front to the back side of the porous membrane and that dispersion medium in a dispersion liquid can be held. In particular, when being impregnated with a solvent, the porous membrane having good wettability to the dispersion medium and good flexibility can be preferably used, because such a porous membrane can adhere closely and easily to the substrate even when the porous membrane is put on the substrate with uneven structure in the wet state.

As schematically shown in Fig. 6(b), when the porous membrane having minute open pores is impregnated with a solvent to wet the porous membrane, the liquid permeates and fills the pores of the porous membrane by so-called capillarity action. And on the surface of the porous membrane, the liquid membrane is formed so as to join the liquids filling the pores. A filmy "liquid-drop wetting on the porous membrane" covering the whole porous membrane is formed.

In the present invention, the porous membrane that can hold the dispersion medium means that the "liquid-drop wetting on the porous membrane" cannot get out of the porous membrane only by action of gravity, because of its very narrow open pores . In the present invention, the porous membrane that can hold the dispersion medium and the substrate are made into a layered structure via the dispersion liquid. Especially, the distance between the porous membrane and the substrate is reduced by atmospheric pressure in the process of removing vapor of the dispersion medium from the surface of the porous membrane, and results in the minute carbon bodies, namely dispersoid, being compressed.

On the top surface of the porous membrane on which the "liquid-drop wetting on the porous membrane" is formed, liquid phases having thicknesses according to pore sizes of the porous membrane can be held, by the surface tension of the liquid drop (dispersion medium) . As is conducted in the suction filtration, the liquid phases can be removed from the open pores of the porous membrane each by putting different pressure on the surface and back of the porous membrane or by contacting dry filter paper to the porous membrane.

The dispersoid in the dispersion liquid can be mainly held on the top surface (supply side of dispersion liquid) of the porous membrane by using the porous membrane whose pores are too narrow for the dispersoid in the dispersion liquid to pass through, capable of holding the dispersion medium. In this context, the porous membrane can be regarded as a container that holds the dispersion liquid on the top surface (supply side of dispersion liquid), mainly because of the surface tension of the dispersion medium.

As the porous membrane that can hold the dispersion medium, the filter generally used for filtration is preferably used. The minute carbon bodies can be held only on the surface of the porous membrane by using such a filter as to hold the filtrated material mainly on the surface of the filter. The foregoing filter is generally called a membrane filter, which is different from ordinary filter paper manufactured by consolidating various fibers.

Membrane filters preferably used are mainly made from PTFE (polytetrafluoroethylene), PVDF (polyvinylidene fluoride), mixed cellulose esters, cellulose acetate, polycarbonate, etc., depending on the type of solvents used as dispersion medium. Membrane filters having a pore size of 0.5 µm or less, 0.1 µm or less, and 0.025 µm or less can be suitably used accordingly.

### (4) Formation of a layered structure composed of the porous membrane, the dispersion liquid, and the substrate:

In case where a dispersion liquid containing minute carbon bodies of high density is used, the dispersion liquid may be dropped on the porous membrane; appropriate techniques such as spin-coating and spraying onto the porous membrane may be conducted; or the porous membrane may be impregnated with the dispersion liquid. The minute carbon bodies of adequate density can be fed by such suitable techniques and gives a carbonaceous structure. A layered structure composed of the substrate, the porous membrane and the dispersion liquid held in-between can be obtained by placing the substrate on the surface of the porous membrane holding the dispersion liquid. Perhaps, when the dispersion liquid is dropped onto the surface of the substrate, a layered structure composed of the substrate, the porous membrane and the dispersion liquid held in-between can be obtained by placing the porous membrane on the surface of the substrate. The point is to use the porous membrane impregnated with an appropriate solvent in advance as a porous membrane placed on the surface of the substrate on which the dispersion liquid was dropped, which is effective in preventing shortage of the dispersion liquid between the substrate and the porous membrane and in forming a layered structure of good quality.

When the dispersion liquid containing the minute carbon bodies of low density is used, the porous membrane is used as a filtration membrane. The dispersion liquid is suction filtrated to concentrate a required amount of the minute carbon bodies on the porous membrane, and then the substrate is placed on the side of the porous membrane where minute carbon bodies exist (mainly on the top surface), which results in compressing a layered structure of the substrate and the porous membrane via a dispersion liquid.

A means of concentrating the minute carbon bodies on the porous membrane includes suction filtration by making use of a pressure difference set up on the porous membrane; a method of removing dispersion medium in the dispersion liquid from the reverse side of porous membrane with filter papers thereon by the surface tension of the dispersion medium; and a method of vaporizing a predetermined ratio of dispersion medium on the porous membrane to which the dispersion liquid is fed.

As described above, when a required amount of the minute carbon bodies is concentrated on the porous membrane by suction filtration using the dispersion liquid containing the minute carbon bodies of low density, it is possible to concentrate the minute carbon bodies on the porous membrane in homogenous density. In particular, in the suction filtration process, CNT fibers get entangled and agglomerates, and as a result the minute carbon bodies are adsorbed weakly and uniformly to the surface of the porous membrane. The agglomerated minute carbon bodies can be prevented from being flown out in the subsequent process, which is desirable. Carbonaceous structures having various layered structures can be formed by using plural kinds of dispersion liquids in order, according to the kind of a carbonaceous structure to be formed.

In case where the minute carbon bodies in the dispersion liquid get dried owing to the excessive removal of dispersion medium, it becomes difficult for the minute carbon bodies to adhere to the porous membrane and to form the carbonaceous structure on the surface of the substrate. Therefore, in order to keep the minute carbon bodies wet, the suction filtration should be stopped with some amount of dispersion medium being left.

When the dispersion medium has to be replaced with different dispersion medium from the dispersion medium contained in the dispersion liquid or when impurities on the minute carbon bodies need to be removed, it is effective to add a suitable solvent to the dispersion liquid in the process of suction filtration. By the suction filtration of the dispersion liquid, the minute carbon bodies can be adsorbed weakly and uniformly into the surface of the porous membrane by suction filtration of the dispersion liquid as described above. Therefore, solvents having lower dispersibility to the minute carbon bodies can be used as substitutes after the suction filtration.

As described above, the porous membrane on which the minute carbon bodies are concentrated by suction filtration of the dispersion liquid is subsequently impregnated with an optional solvent, or the porous membrane contains an adequate amount of dispersion media by feeding a solvent by spraying method, which can suppress the occurrence of wrinkles and shrinkages on the porous membrane. Also, the porous membrane is easily placed on the substrate by the lubricating action, which is preferable.

When the substrate is placed on the porous membrane holding the dispersion liquid (or the porous membrane is placed on the substrate holding the dispersion liquid), the dispersion medium spreads between the porous membrane and the substrate due to capillary action while discharging a gas phase. As a result, the dispersion liquid fills space between the porous membrane and the substrate and gives a layered structure composed of the porous membrane, the liquid phase (dispersion liquid), and the substrate. The thickness of the liquid phase is determined by a kind of dispersion medium. Since the porous membrane of the layered structure is flexible, the isotropic hydrostatic pressure equivalent to atmospheric pressure is generated in the dispersion liquid between the porous membrane and the substrate.

In the superposition process as above described, it should be careful not to leave an unintended gas phase (bubble) between the porous membrane and the substrate and not to corrugate the porous membrane. If necessary, the porous membrane may be pressed to the substrate to the extent that a liquid membrane of the dispersion liquid does not break, so that the dispersion liquid may fill the porous membrane and the substrate thoroughly.

In a layered structure in which the porous membrane and the substrate overlap via the dispersion liquid, at least part of space between the porous membrane and the substrate is filled with the dispersion medium (liquid phase). It is preferable that dispersoid, or minute carbon bodies should be impregnated with dispersion medium, considering the removing procedure in which the minute carbon bodies are compressed and aggregated to discharge the dispersion medium, as explained below.

For example, in case where a membrane-like carbonaceous structure such as a transparent conductive film is formed using the minute carbon bodies, the minute carbon bodies can be held in the liquid membrane by the surface tension of the solvent because the amount of the minute carbon bodies per unit area is small. A desired layered structure can be obtained by compressing the minute carbon bodies in such a condition.

When the amount of the minute carbon bodies per unit area is large (e.g., a discharge electrode made of CNT), a layered structure should be formed while preventing an outflow of the dispersion liquid (dispersion medium) . In forming the layered structure, it is preferable to hold an adequate amount of the dispersion medium with which the minute carbon bodies are impregnated.

In forming the above-mentioned layered structure, the carbonaceous structure can be uniformly formed on the entire surface of the substrate by applying the dispersion liquid containing the minute carbon bodies to the entire surface of the substrate.

When the carbonaceous structure is formed on part of the surface of the substrate, resist mask layers are formed on the surface of the substrate in advance so that the portions in contact with the dispersion liquid can be limited; and by surface modification like this, the minute carbon bodies can join more easily (or become hard to adhere to) the predetermined portion of the substrate. By giving such treatment, the carbonaceous structure can be formed on the predetermined portion of the surface of the substrate.

After the pores in the predetermined area of the porous membrane are squashed, the dispersion liquid may be suction filtrated. Some patterns of the minute carbon bodies may be produced on the porous membrane by drawing properly on the porous membrane using the dispersion liquid. By so doing, when the porous membrane is superposed on the substrate, the carbonaceous structure can be satisfactorily formed on the desired portion of the surface of the substrate.

In forming the layered structure in which the porous membrane and the substrate are overlapped via the dispersion liquid, the dispersion liquid may fully fill the space between the porous membrane and the substrate or may partially fill the portion on which the carbonaceous structure is formed.

In the layered structure in which the porous membrane and the substrate are overlapped via the dispersion liquid, a layer made from the dispersion liquid can be approximately 1 to 1000 µm thick in general. Presumably, the thickness of the dispersion liquid gives a sufficient space as compared to the minute carbon bodies used in the present invention and the dispersoid is also considered to act in a similar way in the dispersion medium. Assuming that the layer made from the dispersion liquid is a reaction container, in the presence of a substance that reacts with the minute carbon bodies in the reaction container, various functions can be imparted to the carbonaceous structure.

### (5) Removal of dispersion medium from the layered structure:

In the layered structure composed of the porous membrane, the dispersion liquid and the substrate formed as described above, the distance between the porous membrane and the substrate is reduced when the dispersion medium is removed mainly from the outside surface of the porous membrane. During the process, the minute carbon bodies are compressed by the isotropic hydrostatic pressure to give a carbonaceous structure.

Dispersion medium can be removed from the layered structure, for example by settling the porous membrane of the layered structure on the upside and vaporizing the dispersion medium from the outside surface of the porous membrane. The speed of removing the solvent from the layered structure can be accelerated by heating the layered structure at an appropriate temperature not more than the boiling point of the dispersion medium. The solvent may be removed from the layered structure by putting an absorber that absorbs solvents (e.g., filter paper) on or applying a negative pressure to the porous membrane of the layered structure. The layered structure may be pressed from the outside if necessary.

The removal of the dispersion medium is not restricted through the porous membrane. It is possible to set up a vent hole on the substrate side or to make the dispersion medium be absorbed into the substrate. Thus, the dispersion medium can be removed from the substrate side.

In the process of removing the dispersion medium, the volume of a liquid membrane on the outside surface of porous membrane decreases first. The liquid membrane on the surface of the porous membrane serves to keep the film thickness more than a certain level due to the surface tension, which sucks the dispersion medium that exists in the open pores of the porous membrane. As a result, the dispersion medium between the porous membrane and the substrate moves to the outside surface of the porous membrane, and the distance between the porous membrane and the substrate is reduced due to the isotropic hydrostatic pressure.

According to the foregoing mechanism, the distance between the porous membrane and the substrate continues to be reduced until the liquid membrane between the porous membrane and the substrate is finally lost due to the reduction of total volume of the dispersion medium. As a result, the dispersoid is sandwiched between the porous membrane and the substrate and subsequently adheres closely to surfaces of the porous membrane and the substrate by the intermolecular force.

After the liquid phase (dispersion medium) is sufficiently vaporized from the surface of the porous membrane or the evaporation is substantially completed, when necessary, the porous membrane is removed from the substrate by proper means. The substrate to which dispersoid such as minute carbon granules adheres is obtained on the surface. The porous membrane is most easily removed by peeling it off the surface of the carbonaceous structure obtained above. If the porous membrane is removed by dissolving in an appropriate solvent, the carbonaceous structure can be formed without being damaged.

The minute carbon bodies are compressed by the isotropic hydrostatic pressure and form the carbonaceous structure being in touch with surfaces of the porous membrane and the substrate. Both of the surfaces are considered to be firmly fixed to the surface of the carbonaceous structure by the intermolecular force depending on the quality of material of the porous membrane and the substrate. Since the effective area of the porous membrane in contact with the carbonaceous structure is small because of its porous structure, adhesion to the carbonaceous structure is small. As a result, a large proportion of the minute carbon bodies are considered to be firmly fixed to the surface of the substrate as the carbonaceous structure after the porous membrane is peeled off. Considering an affinity of the dispersoid, the materials and surfaces of the porous membrane and the substrate may be adjusted. By so doing, the dispersoid can be firmly fixed to the surface of the substrate as the carbonaceous structure in an effective manner.

As described above, the dispersoid in the dispersion medium is aggregated and crimped by making use of the isotropic hydrostatic pressure due to the surface tension of the dispersion medium in the dispersion liquid between the porous membrane and the substrate. This technique has the following advantage as compared to a transfer method in which minute carbon bodies piled on filter paper are pressed to the substrate.

Since the minute carbon bodies act as dispersoid covered with the dispersion medium in the dispersion liquid, the minute carbon bodies can uniformly adhere and be formed on the surface of the substrate as a carbonaceous structure without undesired adhesion, even if the minute carbon bodies are a material easily adhered to other materials because of its strong interaction.

The use of the porous membrane with prescribed flexibility enables the dispersoid to be fixed to the entire surface of the substrate under the same pressure condition. Accordingly, the carbonaceous structure can be evenly formed on the substrate with a large area. Even if the substrate has the uneven and curved surface, the minute carbon bodies can adhere to the substrate under the uniform pressure and form the carbonaceous structure. In the process of a dry filter being pushed against the substrate, the positional deviation tends to occur due to wrinkles and shrinkages locally generated on the filter. In the process of compressing the minute carbon bodies between the porous membrane and substrate well-wetted with the dispersion liquid by the isotropic hydrostatic pressure, not only are wrinkles and shrinkages of the porous membrane eliminated on their own, but also the positional deviation hardly occurs between the porous membrane and the substrate. As a result, the good carbonaceous structure can be formed.

In the process of manufacturing various semiconductor devices having the so-called top contact type structure, for example, when the wiring using the minute carbon bodies is formed on surfaces of various structures formed at the bottom, the carbonaceous structure can be formed by using the dispersion medium which does not influence the bottom structure due to the dissolution. Therefore, the carbonaceous structure can be formed without any substantial pressurization, which thereby leads to prevention of the bottom structure from being damaged.

### Examples

Hereinafter, the method of the present invention is described in more detail with reference to examples. However, the examples shown below are one embodiment of the present invention and the present invention is not restricted thereto.

### [Example 1]

As described below, a CNT coating film as an example of a carbonaceous structure was formed on a PET substrate. An aqueous dispersion of monolayer carbon nanotube (eDIPS INK (EC-DH), manufactured by Meijo Nano Carbon Co., Ltd.) was used as a minute carbon body.

To 1.0 mL of the CNT aqueous dispersion, 0.5 mL of distilled water was added to adjust the concentration, and a membrane filter made of PTFE (Millipore JGWP02500, 25 mmφ, pore size 0.2 µm) which is a porous membrane was sufficiently impregnated with the CNT aqueous dispersion. Next, the filter impregnated with the CNT aqueous dispersion was taken out there and immediately put on a dry PET substrate. The filter on the PET substrate adhered closely to the entire surface of the PET substrate through the CNT aqueous dispersion.

Then, the PET substrate placed on a hotplate was heated and held at 90°C to remove water vapor from the CNT aqueous dispersion. The filter changed from translucent to gray opaque while water vapor was removed. In the process of putting the filter on the PET substrate and removing water vapor, no extra operations, such as pushing the filter were performed. After removal of water vapor, the filter was removed from the PET substrate to reveal the black translucent coating film having the same shape as the filter, on the surface of the PET substrate.

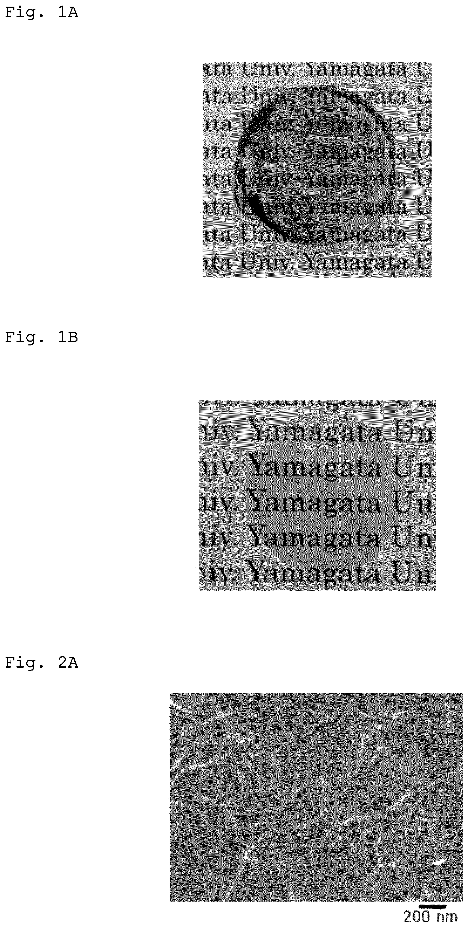

Fig. 1A represents a picture of the black translucent coating film observed at the surface of the PET substrate. Transmission spectrometry (Shimadzu UV-2700; visible light region 380-750 nm) of the PET substrate to which the black translucent coating film adhered showed an average transmittance of 51.6%. The surface resistance measurement (K-705RS manufactured by Kyowa Riken Co., Ltd.) showed a surface resistance of 60.8 Ω/□ showing high conductivity.

The surface resistance measurement confirmed that the black translucent coating film observed at the surface of the PET substrate after removal of the filter, was a CNT thin film. CNTs adhered to the filter in the CNT aqueous dispersion were aggregated and closely adhered to the surface of the PET substrate, which thereby provided the CNT thin film.

The mechanism to form a CNT thin film on the surface of the PET substrate is considered as follows: water vapor of the dispersion medium (water) is vaporized through a filter which closely adheres to and laid on the surface of the PET substrate via a CNT aqueous dispersion. As the space between the filter and the PET substrate is getting narrow, CNTs are compressed and dried between the filter and the substrate, which results in the direct contact without any dispersion medium among CNTs. The direct contact of CNT with the surface of the PET substrate causes CNTs to aggregate and closely adhere to the surface of the PET substrate.

### [Example 2]

A CNT coating film as an example of a carbonaceous structure was produced by a transfer method by using a CNT aqueous dispersion of (eDIPS INK (EC-DH) , manufactured by Meijo Nano Carbon Co., Ltd.).

In order to dilute 1.0 mL of the CNT aqueous dispersion, 9.0 mL of distilled water was added, and 20 µL of the diluted solution was further diluted with 5.0 mL of distilled water to adjust the concentration of the CNT aqueous dispersion. The CNT aqueous dispersion was suction filtrated using a membrane filter made of PTFE (Millipore JGWP02500, 25 mmφ, pore size 0.2 µm) until the dispersion liquid on the filter was almost gone, and CNTs on the filter were concentrated. Some distilled water was poured over the filter and suction filtration was performed three times in order to wash away the dispersant (surfactant) adhered to the CNTs. The suction filtration was stopped just before the dispersion liquid on the filter was completely gone.

After that, the filter taken out of the suction filter was impregnated in a water bath so as to absorb water sufficiently for the prevention of wrinkles and shrinkages, and then the filter was immediately put on a dry PET substrate. The filter on the PET substrate closely adhered to the entire surface of the PET substrate via the aqueous dispersion of CNT. In a similar manner to Example 1, water vapor was removed on a hotplate held at 90°C and then the membrane filter was peeled off, which thereby provided a black translucent coating film formed on the PET substrate.

Fig. 1B represents a picture of the black translucent coating film obtained above. Because the dilute dispersion liquid of CNT was concentrated on the filter by suction filtration, the black translucent coating film was found more homogeneous compared with Example 1. As measured above, the average transmittance of the PET substrate to which the coating film adhered was 80.0% and the surface resistance was 233 Ω/□, which was considered a CNT coating film caused by aggregation of CNT adhered closely to the surface of the PET substrate.

The following consideration will be given in the process of forming the CNT coating films in the foregoing Examples: when the CNT aqueous dispersion was suction filtrated to concentrate CNT on the membrane filter, the CNT in the dispersion liquid weakly adsorbed to the surface of the filter for some mechanism. This is demonstrated by the fact that some CNT remain on the surface of the filter when the filter with concentrated CNT was impregnated in a water bath.

The CNT coating film was formed on the surface of the PET substrate by using the filter with concentrated CNT in a similar manner to Example 1. Presumably, CNT obtained by the suction filtration weakly adsorbed on the surface of the filter, easily adhered to the surface of the PET substrate in the subsequent process, and would form the CNT coating film.

### [Example 3]

A CNT coating film as an example of a carbonaceous structure was formed using a monolayer carbon nanotube prepared by the super-growth method (SWCNT) (ZEON ZEONANO SG101), namely a minute carbon body.

A surfactant, or 50 mg of sodium dodecyl sulfate (Kanto Chemical Co., Inc.; special grade) was dissolved in 5.0 mL of distilled water to which 0.50 mg of the monolayer carbon nanotube (ZEON ZEONANO SG101) was added. The mixture was sonicated for 1 hour by ultrasonic homogenizer (Branson Sonifier 250) to give a CNT aqueous dispersion.

A CNT coating film was formed on the PET substrate in a similar manner to Example 2, except that a CNT aqueous dispersion obtained by dissolving 60 µL the dispersion of CNT in 5.0 mL water was used. As measured above, the average transmittance of the PET substrate to which the CNT coating film adhered was 79.1% and the surface resistance was 2.56 kΩ/□.

### [Example 4]

A CNT coating film as an example of a carbonaceous structure was formed using a monolayer carbon nanotube prepared by eDIPS method (SWCNT) (purity of carbon >99%; center diameter 1 to 3 nm; manufactured by Osaka Soda Co., Ltd.), namely a minute carbon body.

A CNT coating film was formed on the surface of the PET substrate in a similar manner to Example 2, except for the following: 500 mg of sodium dodecyl sulfate, or a surfactant was dissolved in 5.0 mL of distilled water to which 0.50 mg of the monolayer carbon nanotube (manufactured by Osaka Soda Co., Ltd.) was added; the mixture was sonicated for 1 hour by ultrasonic homogenizer; 80 µL of the CNT aqueous dispersion thus obtained was diluted in 5.0 mL of distilled water; and the resulting aqueous dispersion of CNT was used to form a CNT coating film on the PET substrate. As measured above, the average transmittance of the PET substrate to which the CNT coating film adhered was 74.5% and the surface resistance was 270 Ω/□.

The results of Examples 1 to 4 confirm that according to the present invention, CNT coating films can be formed on the substrate, even if CNTs with various properties and condition are manufactured in different manufacturing processes.

### [Example 5]

Minute structures of the CNT coating films in Examples 3 and 4 were confirmed as follows.

A dispersion liquid was prepared in a similar manner to Examples 3 and 4, and a CNT coating film was formed on the glass substrate after the processes of suction filtration. The CNT coating film thus formed was observed with a scanning electron microscope (JEOL JSM-7600F).

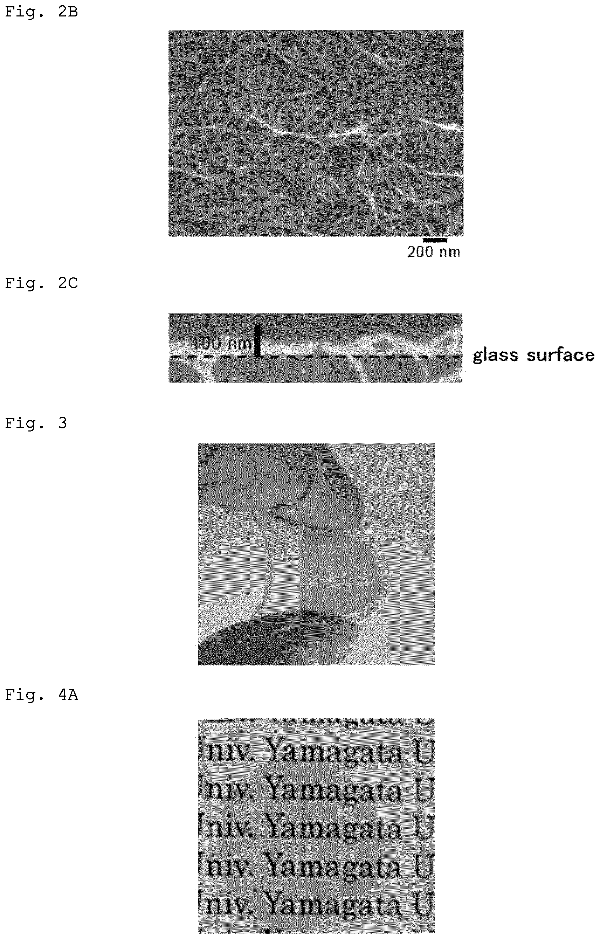

Fig. 2A represents a SEM image of a coating film obtained from CNT prepared by the super-growth method (Example 3). Fig. 2B represents a SEM image of a coating film obtained from CNT prepared by eDIPS method (Example 4). Both of the coating films showed that fibrous CNTs were mutually tangled and adhered to the surface of the substrate.

Fig. 2C represents a SEM image of the section of the glass substrate on which the CNT coating film in Fig. 2B was formed. In Example 4, the CNT coating film formed on the substrate had a thickness of approximately 50 nm.

### [Example 6]

A CNT coating film as an example of a carbonaceous structure was formed using a monolayer carbon nanotube prepared by the super-growth method (SWCNT) (ZEON ZEONANO SG101), namely a minute carbon body and using toluene to disperse CNT.

In order to make the CNT disperse in toluene, 0.50 mg of the monolayer carbon nanotube (ZEON ZEONANO SG101) was added to 5.0 mL of m-cresol (manufactured by Tokyo Chemical Industry Co., Ltd.; >98.0%) and the mixture was sonicated for 2 hours by ultrasonic homogenizer (Branson Sonifier 250) to disperse CNT in m-cresol. The dispersion liquid of CNT was centrifuged (15000 g, 1 hour) with micro refrigerated centrifuge (Kubota 3780) to separate a black supernatant liquid from a precipitate .

A toluene dispersion of CNT was prepared by diluting 100 µL of the centrifuged supernatant liquid with 5 mL of toluene (Kanto Chemical Co., Inc.; special grade). CNT, or dispersoid in the toluene dispersion of CNT was seen to disperse homogeneously in toluene.

The toluene dispersion of CNT thus obtained was suction filtrated using a membrane filter made of PTFE (Millipore JGWP02500, 25 mmφ, pore size 0.2 µm) to concentrate CNT on a filter. The suction filtration was stopped just before the dispersion liquid on the filter was completely gone.

The filter taken out of the suction filter was impregnated in a bath of toluene in order to absorb toluene sufficiently, and then the filter was immediately put on a dry PET substrate. The filter on the PET substrate closely adhered to the entire surface of the PET substrate via the toluene dispersion of CNT. Then, in a similar manner to Example 1, toluene was vaporized and removed on a hotplate held at 70°C and the membrane filter was peeled off, which provided a black translucent coating film formed on the PET substrate.

Fig. 3 represents a picture of the black translucent CNT coating film formed as above. Similarly to Examples 1 to 5 where the aqueous dispersions were used, a CNT coating film was formed even when toluene was used as dispersion medium. As measured above, the average transmittance of the PET substrate to which the coating film adhered was 78.1% and the surface resistance was 2.96 kΩ/□.

Similarly to Example 2, etc., where the CNT aqueous dispersion was used, CNT was observed to substantially remain on the surface of the filter, even if the filter was impregnated in a bath of toluene after the toluene dispersion of CNT was suction filtrated. After the suction filtration, the filter was impregnated in a bath of toluene and the toluene bath was subjected to ultrasonication (AS ONE Corporation; AZU-2M), when CNT was completely removed from the filter in a few seconds.

From the above, it is conceivable that the concentrated CNT was weakly bound to the surface of the filter substantially without being involved with bonds, while taking a easily redispersible form, after the dispersion liquid of CNT was suction filtrated.

According to the present invention, the results from Examples 1 to 6 show that CNT coating films can be formed on substrates by using CNT dispersion liquids with various dispersion media.

### [Example 7]

A CNT coating film as an example of a carbonaceous structure was formed on the surfaces of various substrates other than the PET substrate using a toluene dispersion of CNT prepared in Example 6.

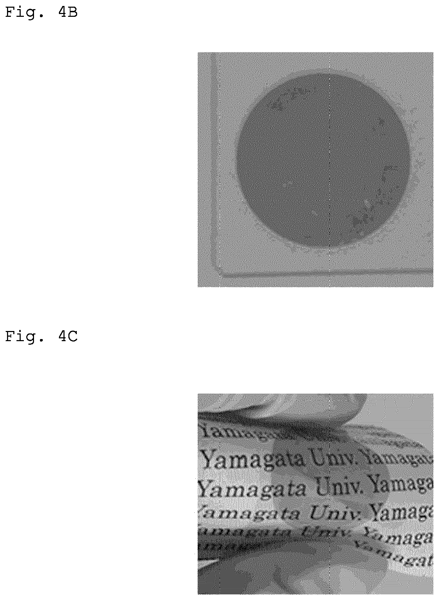

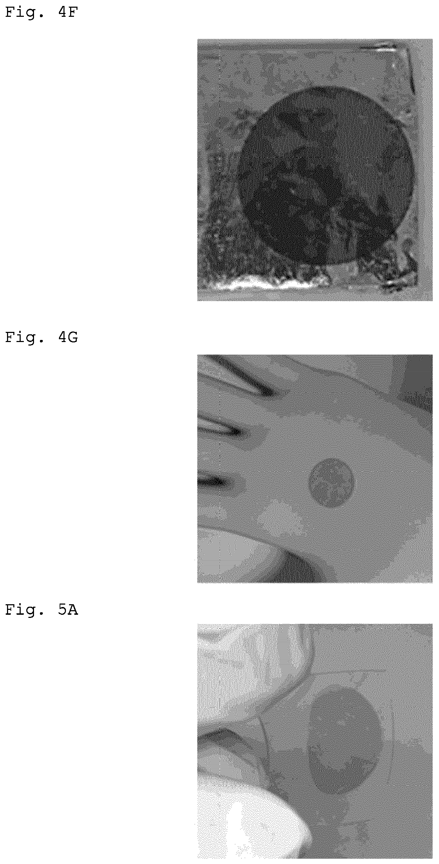

Figs. 4A to 4G represent pictures of CNT coating films formed on the surfaces of various types of materials, which were prepared similarly to Example 6. Besides the glass surface (A), CNT coating films were excellently formed on the glass surface coated with fluorocarbon polymer (Cytop) (B), the surface of polycycloolefin resin (C), and the surface of PTFE resin (D) . The CNT coating films were also excellently formed on the surfaces having some curvature or unevenness, such as the curved surface of glass (E), the surface of aluminum foil (F), and the surface of a rubber glove (nitrile rubber) (G). As clearly shown in the results of Examples 6 and 7, CNT coating films can be formed on the surfaces of the substrates made of various materials or having various surface shapes by the method of the present invention.

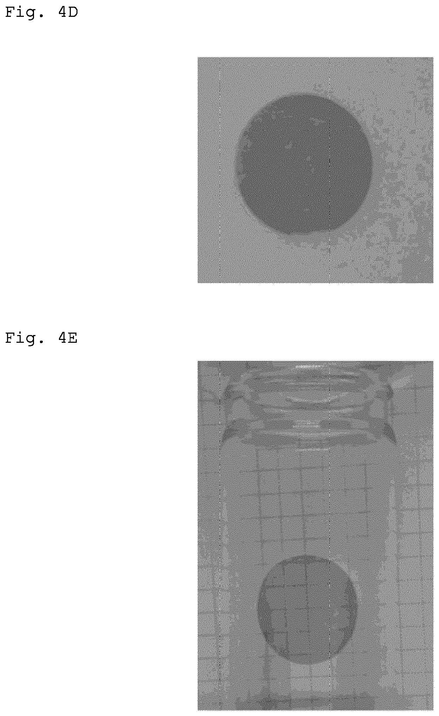

CNT coating films are also excellently formed on the surface of PTFE resin made of the same material as a membrane filter made of PTFE (Millipore JGWP02500, 25 mmφ, pore size 0.2 µm) used as a porous membrane (Fig. 4D). It is conceivable that due to the difference in effective contact areas between the dried CNT coating film and the filter/substrate, the CNT coating film, which was compressed and dried between the filter and the substrate, adhered to especially the surface of the substrate. Presumably, the CNT coating film with a larger effective area is left on the substrate side in contact with the CNT coating film, when the filter is peeled off.

A CNT coating film was also excellently formed on the surfaces having some curvature or unevenness (Figs. 4E to 4G), which indicates that the porous membrane can closely adhere to the details of the substrate because of the surface tension of the dispersion liquid and can form CNT coating films by making use of a more flexible porous membrane.

### [Example 8]

The dispersion medium for minute carbon bodies, which was used for the formation of the carbonaceous structure, was replaced with other solvent and so on and then a CNT coating film as an example of a carbonaceous structure was formed in the same way as above.

A surfactant, or 500 mg of sodium dodecyl sulfate was dissolved in 5.0 mL of distilled water to which 0.50 mg of SWCNT prepared by eDIPS method was added, and the mixture was sonicated for 1 hour by ultrasonic homogenizer to prepare a CNT aqueous dispersion. Next, 80 µL of the CNT aqueous dispersion was diluted with 2.0 mL of water and 3 . 0 mL of methanol to prepare a CNT aqueous dispersion, whose dispersion medium was a mixed solvent of water and methanol. The CNT aqueous dispersion was suction filtrated through a membrane filter made of PTFE (Millipore JGWP02500, 25 mmφ, pore size 0.2 µm) until the dispersion liquid on the filter was almost gone, and CNT on the filter was concentrated. Some methanol was poured over the filter and suction filtration was performed three times. The suction filtration was stopped just before the dispersion liquid on the filter was completely gone.

The filter was taken out of the suction filter and impregnated in a bath of toluene to absorb toluene sufficiently. In other words, the dispersion medium of the CNT aqueous dispersion was replaced with methanol, and then the dispersion medium was replaced with toluene. The filter was immediately put on a dry PET substrate. The filter closely adhered to the entire surface of the PET substrate via the toluene dispersion of CNT. In a similar manner to Example 6, toluene was vaporized and removed on a hotplate held at 70°C and the membrane filter was peeled off, which thereby provided a black translucent CNT coating film formed uniformly on the surface of the PET substrate.

The average transmittance of the PET substrate on which the CNT coating film was formed was 71.3% and the surface resistance was 170 Ω/□. This CNT coating film was comparable in properties to the CNT coating film obtained from the same SWCNT by using the CNT aqueous dispersion of as shown in Example 4.

### [Example 9]

A CNT/graphene composite coating film as an example of a carbonaceous structure was formed using a monolayer carbon nanotube prepared by the super-growth method (SWCNT) (ZEON ZEONANO SG101) as a minute carbon body and graphene (iGurafen-as 180020C manufactured by ITEC Corporation).

To make the CNT and graphene disperse in toluene, 0.45 mg of a monolayer carbon nanotube (ZEON ZEONANO SG101) and 0.050 mg of graphene (iGurafen-as 180020C) were added to 5.0 mL of m-cresol (manufactured by Tokyo Chemical Industry Co., Ltd.; >98.0%), and the mixture was sonicated for 2 hours to disperse CNT and graphene in m-cresol. The dispersion of CNT was centrifuged at 15000g for 1 hour with micro refrigerated centrifuge (Kubota 3780) to separate a black supernatant liquid from a precipitate.

A toluene dispersion was prepared by diluting 100 µL of the centrifuged supernatant liquid with 5 mL of toluene (Kanto Chemical Co., Inc.; special grade). CNT and graphene as dispersoids were homogeneously dispersed in toluene of the toluene dispersion.

In a similar manner to Example 6, a mixture of CNT and graphene was concentrated on the filter by suction filtration, and mixed coating films were formed on the PET substrate and the glass substrate.

Fig. 5A represents a picture of the mixed film of CNT and graphene formed on the PET substrate. As shown in Fig. 5A, the mixed film of CNT and graphene thus formed was black translucent. As measured above, the average transmittance of the PET substrate to which the coating film adhered was 87.0% and the surface resistance was 8.65 kΩ/□.

Fig. 5B represents a SEM image of a mixed film of CNT and graphene formed on the glass substrate. The SEM image confirmed that CNT and graphene were mixed and formed into a coating film. [Comparative Example 1]

In a similar manner to Example 6, a toluene dispersion of CNT was prepared by dispersing a monolayer carbon nanotube prepared by the super-growth method (SWCNT) (ZEON ZEONANO SG101) in toluene (Kanto Chemical Co., Inc.; special grade), and the toluene dispersion of CNT was suction filtrated through a membrane filter made of PTFE (Millipore JGWP02500, 25 mmφ, pore size 0.2 µm) to concentrate CNT on the filter.

The filter taken out of the suction filter was left in air for a long time to be dried enough. The filter changed from translucent to gray opaque after dried. The dried filter placed on the PET substrate was uniformly compressed by a pressure of approximately 1 kg/cm² so that the filter could closely adhere to the PET substrate. Then, the filter was taken out of the PET substrate. Nearly all CNT were left on the filter and no CNT coating film was formed on the PET substrate.

### [Comparative Example 2]

In a similar manner to Comparative Example 1, the filter on which CNT was concentrated was well-dried and impregnated in a bath of toluene in order to absorb toluene sufficiently. The filter was immediately put on a dry PET substrate. Impregnated with toluene, the well-dried filter got wet immediately and became translucent. No dispersion of CNT was observed in a bath of toluene, which confirmed that CNT was left on the surface of the filter. The wet filter was put on the surface of the PET substrate so as to closely adhere to the entire surface of the PET substrate.

In a similar manner to Example 6, toluene was vaporized and removed on a hotplate held at 70°C, and the filter was peeled off. Nearly all CNT were left on the filter. No CNT coating film was formed on the surface of the PET substrate.

The filter was impregnated in a bath of toluene and the toluene bath was subjected to ultrasonication (AS ONE Corporation; AZU-2M) . It took a few minutes to drive CNT nearly perfectly from the filter, which was very unlike in the case where no drying process was carried out (Example 6, etc.,).

From the above results, the CNT coating film could not be formed on the surface of the PET substrate, unlike Example 6, for the following reason: CNT directly contacted the filter when the filter was dried and the dispersion medium covering the CNT' s surface was removed. As a result, CNT was physically adsorbed onto the filter, which prevented CNT from dispersing again in toluene, even if the filter was impregnated in a bath of toluene.

### Industrial Applicability

The method for forming a carbonaceous structure of the present invention can be excellently utilized in the formation of carbonaceous structures including various minute carbon bodies.

## Claims

1. A method for forming a carbonaceous structure on the surface of a substrate, comprising
a step of forming a layered structure by at least partially filling a gap between a porous membrane which can hold a dispersion medium and the substrate with a minute-carbon-body dispersion liquid comprising the minute carbon bodies and the dispersion medium, and
a step of removing the dispersion medium by at least partially taking the dispersion medium out of the layered structure through the porous membrane and/or the substrate.

2. The method for forming a carbonaceous structure according to claim 1, wherein the layered structure is formed to overlay the substrate with the porous membrane on which the minute-carbon-body dispersion liquid is held by suction filtration for the minute-carbon-body dispersion liquid.

3. The method for forming a carbonaceous structure according to claim 1, wherein the porous membrane on which the minute-carbon-body dispersion liquid is held by suction filtration for the minute-carbon-body dispersion liquid is further soaked in a solvent, and then is overlaid on the substrate to form the layered structure.

4. The method for forming a carbonaceous structure according to claim 2 or 3, wherein the dispersion medium contained in the minute-carbon-body dispersion liquid is replaced with other dispersion medium in the suction filtration process.

5. The method for forming a carbonaceous structure according to any one of claims 1 to 4, wherein the dispersion medium is vaporized through the pores of the porous membrane in the step of removing the dispersion medium.

6. The method for forming a carbonaceous structure according to any one of claims 1 to 5, further comprising a step of removing the porous membrane from the carbonaceous structure thus formed.

7. The method for forming a carbonaceous structure according to claim 6, wherein the step of removing the porous membrane is to peel the porous membrane off the carbonaceous structure.

8. A substrate of a carbonaceous structure containing minute carbon bodies, wherein through a porous membrane and/or the substrate, the carbonaceous structure is formed in the process of at least partially taking a dispersion medium out of a layered structure obtained by at least partially filling a gap between the porous membrane which can hold the dispersion medium and the substrate with a minute-carbon-body dispersion liquid comprising the minute carbon bodies and the dispersion medium.
